Europäisches Patentamt

European Patent Office

Office européen des brevets

(19)

(11) Veröffentlichungsnummer: **0 084 358**
**A2**

(12) **EUROPÄISCHE PATENTANMELDUNG**

(21) Anmeldenummer: **83100299.3**

(22) Anmeldetag: **14.01.83**

(51) Int. Cl.³: **G 11 B 5/09**
**//H03K5/153**

(30) Priorität: **18.01.82 DE 3201318**

(43) Veröffentlichungstag der Anmeldung:
**27.07.83 Patentblatt 83/30**

(84) Benannte Vertragsstaaten:
**FR GB IT SE**

(71) Anmelder: **TANDBERG DATA A/S**
**Kjelsasveien 161 Postboks 9 Korsvoll**
**N-Oslo 8(NO)**

(72) Erfinder: **Lia, Herman**
**Liakollen 58A**
**N-1481 Li(NO)**

(74) Vertreter: **Mehl, Ernst, Dipl.-Ing. et al,**
**Postfach 22 01 76**
**D-8000 München 22(DE)**

(54) Verfahren und Schaltungsanordnung zum Bewerten von Lesesignalen eines Magnetschichtspeichers.

(57) Bei dem Verfahren werden die von einem Lesekopf (K) eines Magnetschichtspeichers abgegebenen Lesesignale (L) zunächst in an sich bekannter Weise verstärkt und differenziert. Wenn die differenzierten Lesesignale (L2) in den Nulldurchgängen eine genügende Steigung aufweisen, werden an den Nulldurchgängen Datenimpulse (D) erzeugt. Die Überprüfung der Steigung erfolgt durch eine nochmalige Differentation der differenzierten Lesesignale (L2) und durch eine Überprüfung, ob diese zweifach differenzierten Lesesignale (L3) vorgegebene Schwellenspannungen (S) über- oder unterschreiten.

FIG 2

Tandberg Data A/S        Unser Zeichen

Oslo                   VPA 82 P 8001 E

Verfahren und Schaltungsanordnung zum Bewerten von Lesesignalen eines Magnetschichtspeichers

Die Erfindung bezieht sich auf ein Verfahren und eine Schaltungsanordnung zum Bewerten von Lesesignalen eines Magnetspeichers entsprechend dem Oberbegriff des Patentanspruchs 1.

Für die Bewertung von Lesesignalen, die in einem Magnetschichtspeicher, beispielsweise einem Magnetbandgerät beim Lesen von auf einem magnetischen Aufzeichnungsträger aufgezeichneten Daten an einem Magnetkopf abgegeben werden, ist es allgemein bekannt, diese Lesesignale zunächst mittels eines Vorverstärkers zu verstärken und dann die Lesesignale in einer Differenzierstufe zu differenzieren. Die Differenzierstufe kann neben dem eigentlichen Differenzierglied ein Filternetzwerk, insbesondere einen Tiefpaß zum Befestigen von Störungen enthalten. Die Differenzierstufe kann auch als Entzerrerfilter ausgebildet sein, das in einem vorgegebenen Frequenzbereich eine differenzierende Wirkung aufweist und gleichzeitig unerwünschte Spitzenverschiebungen der Lesesignale beseitigt und das bei hohen Frequenzen die Wirkung eines Tiefpasses hat. Ein derartiges Entzerrerfilter ist beispielsweise aus der US-PS 34 05 403 bekannt. An den Nulldurchgängen der differenzierten Lesesignale werden Datenimpulse erzeugt, die einer Auswertestufe zugeführt werden, um die gespeicherten digitalen Daten wiederzugewinnen.

Zum Schutz gegen Störimpulse, die im Lesesignal enthalten sein können, wird üblicherweise vor der Erzeugung der Datenimpulse eine Qualitätsprüfung der Lesesignale durchge-

Ret 1 Obh / 15. Jan. 1982

führt. Diese Qualitätsprüfung erfolgt beispielsweise dadurch, daß die Datenimpulse nur dann freigegeben werden, wenn während der Nulldurchgänge der differenzierten Lesesignale die ursprünglichen Lesesignalen vorgegebene positive Schwellenspannungen über- oder vorgegebene negative Schwellenspannungen unterschritten haben. Aus IBM Technical Disclosure Bulletin, Vol. 23, No. 10, März 1981, Seite 4639 bis 4641 ist es bekannt, für die Qualitätsprüfung der Lesesignale die differenzierten Lesesignale zu verwenden. Nur dann, wenn die differenzierten Lesesignale nach einem Nulldurchgang die vorgegebenen Schwellenspannungen über- bzw. unterschreiten, werden die entsprechenden Datenimpulse abgegeben. Zu diesem Zweck werden bei den Nulldurchgängen Impulse erzeugt, deren Impulsdauer derart gewählt ist, daß die Rückflanke der Impulse immer dann auftritt, wenn das zugehörige differenzierte Lesesignal die entsprechende Schwellenspannung über- bzw. unterschritten hat.

Bei dieser bekannten Qualitätsprüfung der Lesesignale bleibt die Steigung der differenzierten Lesesignale beim Nulldurchgang außer Betracht. Falls das Lesesignal nur eine geringe Steigung aufweist, und die Schwellenspannungen verhältnismäßig spät überschritten werden, können Fehler bei der Bewertung der Lesesignale auftreten.

Falls für die Qualitätsprüfung die ursprünglichen Lesesignale selbst genutzt werden, kann der Fall eintreten, daß infolge einer Überlagerung einer niederfrequenten Wechselspannung in Abhängigkeit von der Folge der aufgezeichneten Bits die Schwellenspannungen nicht erreicht werden, und daß damit keine Datenimpulse erzeugt werden.

Der Erfindung liegt die Aufgabe zugrunde, ein Verfahren und eine Schaltungsanordnung anzugeben, bei deren Verwendung die Datenimpulse aus den Lesesignalen mit großer Sicherheit wiedergewonnen werden.

Erfindungsgemäß wird die Aufgabe bei dem Verfahren der eingangs genannten Art gelöst durch die im kennzeichnenden Teil des Patentanspruchs 1 angegebenen Merkmale.

Der Erfindung liegt der Gedanke zugrunde, die Steigung der diffe-renzierten Lesesignale beim Nulldurchgang für die Qualitätsprüfung zu benutzen. Ein Datenimpuls wird daher nur dann abgegeben, wenn das differenzierte Lesesignal beim Nulldurchgang eine vorgegebene Steigung aufweist. Auf diese Weise wird einerseits verhindert, daß Wechselspannungskomponenten im Lesesignal oder Einsattelungen im differenzierten Lesesignal fälschlicherweise zur Erzeugung von Datenimpulsen führen. Die Vorderflanken der Datenimpulse stimmen sehr gut mit den Nulldurchgängen der differenzierten Lesesignale überein, und auf die Verwendung von monostabilen Kippstufen und Verzögerungsgliedern kann bei der eigentlichen Qualitätsprüfung verzichtet werden.

Bei einer vorteilhaften Schaltungsanordnung zur Durchführung des Verfahrens ist der Differenzierstufe, die die differenzierten Lesesignale erzeugt, eine weitere Differenzierstufe nachgeschaltet, die die zweifach differenzierten Lesesignale an eine Vergleichsstufe abgibt, die ihrerseits Schwellenimpulse erzeugt. Eine Schaltstufe erzeugt immer dann die Datenimpulse, wenn während der Nulldurchgänge der differenzierten Lesesignale die entsprechenden Schwellenimpulse vorhanden sind.

Die weitere Differenzierstufe enthält zweckmäßigerweise zwei Differenzierglieder, die jeweils gegentaktig ausgebildet sind, und die jeweils die differenzierten Lesesignale einer Polarität bewerten. Jedem dieser Differenzierglieder ist ein Verstärker nachgeschaltet, der die zweifach differenzierten Lesesignale mit den Schwellenspannungen vergleicht, und die Schwellenimpulse an die Schaltstufe abgibt. Die Schaltstufe ist bei einer vorteilhaften Ausführungsform als Analog-Digital-Umsetzer ausgebildet, an dessen Analogeingang die differenzierten Lesesignale anliegen, an dem die Schwellenimpulse anliegen und der die Datenimpulse abgibt. Dem Analog-Digital-Umsetzer kann ein Impulsformer nachgeschaltet sein, der vorzugsweise als monostabile Kippstufe ausgebildet ist, und der jeweils Datenimpulse gleicher Impulsdauer erzeugt.

Das Verfahren gemäß der Erfindung und ein bevorzugtes Ausführungsbeispiel einer Schaltungsanordnung zur Durchführung des Verfahrens wird im folgenden anhand von Zeichnungen näher erläutert. Es zeigen

Fig. 1 ein Blockschaltbild einer Schaltungsanordnung zum Bewerten von Lesesignalen eines Magnetschichtspeichers,

Fig. 2 Zeitdiagramme von Signalen an verschiedenen Punkten der Schaltungsanordnung und

Fig. 3 ein Schaltbild eines Teils der Schaltungsanordnung.

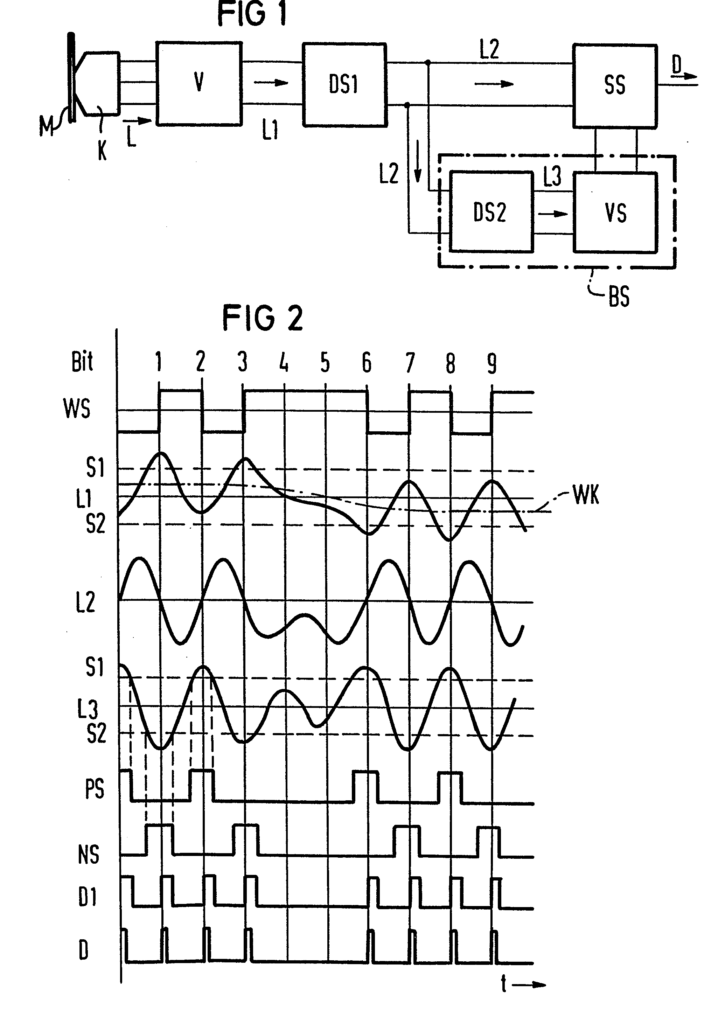

Bei dem in Fig. 1 dargestellten Blockschaltbild sind auf einem magnetischen Aufzeichnungsträger M digitale Daten durch entsprechende Magnetisierungswechsel gespeichert. Die Wiedergewinnung der aufgezeichneten Daten erfolgt unter Verwendung eines Lesekopfs K, der entsprechende Lesesignale an einen Vorverstärker V abgibt. Dieser Vorverstärker ist als linearer Verstärker, vorzugsweise als Differenzverstärker, ausgebildet. Die verstärkten Lesesignale L1 werden einer Differenzierstufe DS1 zugeführt, die die Lesesignale L1 differenziert und differenzierte Lesesignale L2 erzeugt. Die Differenzierstufe DS1 ist in bekannter Weise als Differenzierglied mit nachgeschaltetem Tiefpaß oder als differenzierendes Entzerrerfilter ausgebildet. Die differenzierten Lesesignale L2 liegen an einer Schaltstufe SS an, die an den Nulldurchgängen der differenzierten Lesesignale L2 Datenimpulse D erzeugt und diese einer nicht dargestellten Auswertestufe zuführt, die entsprechend der für die Speicherung verwendeten Codierung aus den Datenimpulsen die digitalen Daten wiedergewinnt. Bekannte Codierungen sind beispielsweise die Richtungstaktschrift, die MFM-Schrift oder GCR-Schrift.

Zur Erhöhung der Störsicherheit werden die Datenimpulse D jedoch nur dann abgegeben, wenn die Lesesignale L bestimmte Qualitätsanforderungen erfüllen. Zu diesem Zweck ist eine Bewerterstufe BS vorgesehen, die immer dann Schwellensignale PS oder NS erzeugt, wenn die Steigung der differenzierten Lesesignale L2 vorgegebene Werte überschreitet. Zu diesem Zweck enthält die Bewerterstufe BS eine weitere Differenzierstufe DS2, die die differenzierten Lesesignale L2 nochmals differenziert und zweifach differenzierte Lesesignale L3 erzeugt. Diese werden einer Vergleicherstufe VS zugeführt, die immer dann die Schwellenimpulse PS bzw. NS erzeugt, wenn die zweifach differenzierten Lesesignale L3 vorgegebene positive Schwellenspannungen über- bzw. vorgegebene negative Schwellenspannungen unterschreiten. Nur wenn bei einem Nulldurchgang der differenzierten Lesesignale L2 diese Schwellenimpulse PS oder NS vorhanden sind, wird ein entsprechender Datenimpuls D erzeugt.

Weitere Einzelheiten werden im folgenden zusammen mit den in Fig. 2 dargestellten Zeitdiagrammen beschrieben.

Bei den in Fig. 2 dargestellten Zeitdiagrammen ist in Abszissenrichtung die Zeit t aufgetragen. In Ordinatenrichtung sind die Momentanwerte von Signalen an verschiedenen Punkten der Schaltungsanordnung dargestellt. Außerdem ist der Verlauf eines Schreibstroms dargestellt, wenn neun Bits mit vorgegebenen Binärwerten auf den magnetischen Aufzeichnungsträger M aufgezeichnet werden sollen. Dieser Schreibstrom WS entspricht einem idealisierten Verlauf der Magnetisierung auf dem magnetischen Aufzeichnungsträger M.

Jede Änderung des Schreibstroms WS entspricht einem Extremwert, der vom Magnetkopf K beim Lesen der aufgezeichneten Daten erzeugten Lesesignale L bzw. der verstärkten Lesesignale L1. Wie zu erkennen ist, liegen die Extremwerte nicht symmetrisch zur Nullinie, da entsprechend dem gewählten Verlauf des Schreibstroms WS und damit der Magnetisierungswechsel eine niederfrequente Wechselspannungskomponente WK auftritt. Mittels der Differenzierstufe DS1 werden die Lesesignale L1 differenziert, so daß jeder Extremwert der Lesesignale L1 einem Nulldurchgang der entzerrten Lesesignale L2 entspricht. Die Wechselspannungskomponente WK ist in den differenzierten Lesesignalen L2 nicht mehr enthalten. Die Schaltstufe SS erzeugt immer dann, wenn die Schwellenimpulse PS und NS vorhanden sind, die Datenimpulse D1 bzw. D, deren Vorderflanken mit den Nulldurchgängen der differenzierten Leseimpulse L2 übereinstimmen.

Zur Erzeugung der Schwellenimpulse PS und NS wäre es denkbar, die Leseimpulse L1 zu verwenden. Das Lesesignal L1 müßte in diesem Fall der Vergleichsstufe VS zugeführt werden. Immer dann, wenn die Lesesignale L1 eine positive Schwellenspannung S1 bzw. eine negative Schwellenspannung S2 über- bzw. unterschreiten, würden dann die Schwellenimpulse NS bzw. PS erzeugt werden. Infolge der Wechselspannungskomponente WK könnte es, wie in Fig. 2 zu erkennen ist, jedoch zu einer fehlerhaften Bewertung der Lesesignale L1 kommen, da beispielsweise bei den Bits 2 und 7 die Schwellenspannungen S2 bzw. S1 nicht unter- bzw. überschritten werden.

Es erweist sich als zweckmäßig, für die Erzeugung der Schwellenimpulse PS und NS die am Ausgang der weiteren Differenzierstufe DS2 abgegebenen zweifach differenzierten Lesesignale L3 zu verwenden, da die Momentanwerte dieser Lesesignale L3 unmittelbar die Steigung der differenzierten Lesesignale L2 angeben. Die Vergleichsstufe VS erzeugt immer dann, wenn die zweifach differenzierten Lesesignale L3 eine positive Schwellenspannung S1 bzw. eine negative Schwellenspannung S2 über- bzw. unterschreiten, die Schwellenimpulse PS bzw. NS.

In der Schaltstufe SS werden die Schwellenimpulse PS und NS verwendet, um einen Analog-Digital-Umsetzer jeweils für die Dauer ihres Auftretens freizugeben.

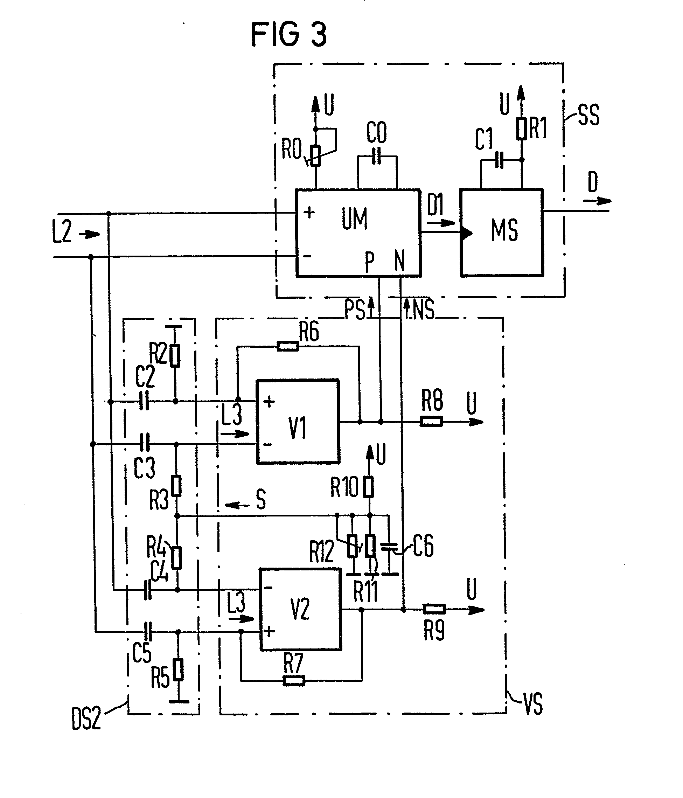

Das in Fig. 3 dargestellte Schaltbild zeigt den Aufbau der Schaltstufe SS und der Bewerterstufe BS.

Die Schaltstufe SS enthält einen Analog-Digital-Umsetzer UM, dessen differenziellem Eingang die differenzierten Lesesignale L2 zugeführt werden, und an dessen Steuereingängen P und N die Schwellenimpulse PS und NS anliegen. Derartige Umsetzer UM sind allgemein bekannt und im Handel unter der Bezeichnung 8T20 von der Firma Signetics Corp., USA erhältlich. Wenn ein Schwellenimpuls PS vorhanden ist und gleichzeitig das differenzierte Lesesignal L2 mit positiver Steigung die Nullinie überschreitet, gibt der Umsetzer UM einen Datenimpuls D1 ab. Der Umsetzer UM erhält eine monostabile Kippstufe, die den Datenimpuls D1 erzeugt. Mittels des Widerstands RO und des Kondensators CO wird das Tastverhältnis des Datenimpulses D1 bei der höchsten vorkommenden Datenfrequenz von beispielsweise 450kHz auf 50% eingestellt. Entsprechendes gilt, wenn der Schwellenimpuls NS vorhanden ist, und das differenzierte Lesesignal L2 die Nullinie in negativer Richtung überschreitet. Dem Umsetzer UM ist ein Impulsformer nachgeschaltet, der als monostabile Kippstufe MS ausgebildet ist. Die monostabile Kippstufe MS erzeugt den Datenimpulsen D1 zugeordnete Datenimpulse D mit konstanter Impulsdauer, die durch den Widerstand R1 und den Kondensa-

BAD ORIGINAL

tor C1 bestimmt wird.

Die Differenzierstufe DS2 wird aus zwei Differenziergliedern gebildet, die in der Vergleichsstufe VS jeweils einem als Vergleicher dienenden Differenzverstärker V1 bzw. V2 vorgeschaltet sind. Die Differenzierglieder sind gegentaktig ausgebildet und bestehen aus jeweils zwei CR-Gliedern, C2R2 und C3R3 bzw. C4R4 und C5R5. Die Verstärker V1 und V2 sind an sich bekannt und unter der Bezeichnung LM311 von der Firma National Semiconductor, USA im Handel erhältlich. Sie sind jeweils mit einem Gegenkopplungswiderstand R6 bzw. R7 und einem weiteren Widerstand R8 bzw. R9, der als Kollektorwiderstand eines Ausgangstransistors dient, beschaltet. Den invertierenden Eingängen der Verstärker V1 und V2 wird über die Widerstände R3 bzw. R4 die Schwellenspannung S zugeführt, die unter Verwendung eines Spannungs-teilers aus den Widerständen R10 und R12 erzeugt wird. Mit Hilfe des Widerstands R12 ist die Schwellenspannung S einstellbar. Zusätzlich kann parallel zu den Widerständen R11 und R12 ein Transistor angeordnet sein, der beim Lesen von Daten leitend gesteuert ist und einen weiteren Widerstand parallelschaltet. Beim Schreiben von Daten und einem damit gleichzeitig durchgeführten Kontrollesen ist der Transistor gesperrt. Auf diese Weise wird beim Kontrollesen eine höhere Schwellenspannung S als beim Nurlesen erzeugt. Die differenzierten Lesesignale L2 werden den Verstärkern V1 und V2 über die Differenzierglieder invers zueinander zugeführt, so daß diese in Abhängigkeit von der Polarität der differenzierten Lesesignale L2 wechselweise die Schwellenimpulse PS und NS erzeugen, wenn die differenzierten Lesesignale L2 die Schwellenspannung S betragsmäßig jeweils überschreiten.

10 Patentansprüche

3 Figuren

Patentansprüche

1. Verfahren zum Bewerten von Lesesignalen eines Magnetschichtspeichers, wobei in einem Lesekopf Lesesignale erzeugt werden, die in einem Vorverstärker verstärkt und in einer Differenzierstufe differenziert werden und wobei an den Nulldurchgängen der differenzierten Lesesignale Datenimpulse erzeugt werden, wenn den Datensignalen zugeordnete Signale vorgegebene Schwellenwerte überschritten haben, g e k e n n z e i c h n e t   d u r c h   folgende Verfahrensschritte:

a) aus den differenzierten Lesesignalen (L2) werden nach einer weiteren Differentation zweifach differenzierte Lesesignale (L3) erzeugt,

b) wenn die zweifach differenzierten Lesesignale vorgegebene Schwellenwerte (S1,S2) über- bzw. unterschreiten, werden entsprechende Schwellenimpulse (PS,NS) erzeugt,

c) an den Nulldurchgängen der differenzierten Lesesignale (L2) werden nur dann die Datensignale (D,D1) erzeugt, wenn gleichzeitig die entsprechenden Schwellenimpulse (PS,NS) vorhanden sind.

2. Verfahren nach Anspruch 1,
d a d u r c h   g e k e n n z e i c h n e t , daß für jede Polarität der zweifach differenzierten Lesesignale (L3) getrennte Schwellenimpulse (PS,NS) erzeugt werden.

3. Verfahren nach Anspruch 1 oder 2,
d a d u r c h   g e k e n n z e i c h n e t , daß Datenimpulse (D) mit jeweils gleicher Impulsdauer erzeugt werden.

4. Schaltungsanordnung zur Durchführung des Verfahrens nach Anspruch 1, bei dem der Lesekopf ein die Lesesignale verstärkender Vorverstärker und eine die Lesesignale differenzierende Differenzierstufe nachgeschaltet sind, und

0084358

bei der die differenzierten Lesesignale an einer Schaltstufe anliegen, an deren Ausgang die Datenimpulse abgegeben werden,
d a d u r c h   g e k e n n z e i c h n e t , daß eine Bewerterstufe (BS) vorgesehen ist, die eine weitere Differenzierstufe (DS2) enthält, an der die differenzierten Lesesignale (L2) anliegen, und die die zweifach differenzierten Lesesignale (L3) erzeugt, und daß die Bewerterstufe (BS) eine Vergleichsstufe (VS) enthält, die immer dann die Schwellenimpulse (PS,NS) an die Schaltstufe (SS) abgibt, wenn die zweifach differenzierten Lesesignale (L3) vorgegebene Schwellenspannungen (S1,S2) über- bzw. unterschreiten.

5. Schaltungsanordnung nach Anspruch 4,
d a d u r c h   g e k e n n z e i c h n e t , daß die weitere Differenzierstufe (DS2) zwei Differenzierglieder (C2 R2 und C3 R3, C4 R4 und C5 R5) enthält, von denen jedes einer Polarität der differenzierten Lesesignale (L2) zugeordnet ist.

6. Schaltungsanordnung nach Anspruch 5,
d a d u r c h   g e k e n n z e i c h n e t , daß die Differenzierglieder aus jeweils zwei CR-Gliedern (C2 R2 und C3 R3, C4 R4 und C5 R5) bestehen, und daß an jeweils einem Widerstand (R3, R4) der CR-Glieder die Schwellenspannung (S) anliegt.

7. Schaltungsanordnung nach einem der Ansprüche 4 bis 6,
d a d u r c h   g e k e n n z e i c h n e t , daß die Vergleichsstufe (VS) zwei Differenzverstärker (V1,V2) enthält, von denen jeder einer Polarität der differenzierten Lesesignale (L2) zugeordnet ist.

8. Schaltungsanordnung nach einem der Ansprüche 4 bis 7,
d a d u r c h   g e k e n n z e i c h n e t , daß die Schaltstufe (SS) einen Umsetzer (UM) enthält, an dessen dif-

ferentiellem Eingang die differenzierten Lesesignale (L2) und an dessen Steuereingängen (P,N) die Schwellenimpulse (PS,NS) anliegen und der die Datenimpulse (D1) erzeugt.

9. Schaltungsanordnung nach Anspruch 8, d a d u r c h   g e k e n n z e i c h n e t , daß dem Umsetzer (UM) ein Impulsformer (MS) nachgeschaltet ist, der aus den Datenimpulsen (D1) Datenimpulse (D) mit gleicher Impulsdauer erzeugt.

10. Schaltungsanordnung nach einem der Ansprüche 4 bis 9, d a d u r c h   g e k e n n z e i c h n e t , daß die Schwellenspannungen (S,S1,S2) einstellbar sind.

FIG 1

FIG 2

0084358

2/2

FIG 3